# EUROPEAN PATENT APPLICATION

(11) **EP 0 656 648 A1**
(43) Date of publication of application: **07.06.1995**
(21) Application number: 94118904.5
(22) Date of filing: 01.12.1994
(51) Int. Cl.: H01L 21/58

(54) **Circuit and method of using an oxide layer to attach a semiconductor die to a die pad**

(30) Priority: 03.12.1993 US 161018
(71) Applicant: MOTOROLA INC., Schaumburg, Illinois 60196 (US)
(72) Inventor: Berg, Howard Martin, Scottsdale, Arizona 85260 (US); Ganesan, Sankaranarayanan, Chandler, Arizona 85226 (US)
(74) Representative: Hudson, Peter David

(57) **Abstract**

An adhesion material (30) and oxide layer (28) are deposited on the top layer of the die pad (26) of a semiconductor package (12) to attach a semiconductor die (32) to a die pad of the package. An oxide layer (28) is deposited on top of the die pad. The oxide layer can be a chemically grown cuprous oxide. A die attach adhesive (30) such as a polymer material is deposited on top of the oxide layer, and the semiconductor die is attached to the die pad with the die attach adhesive. The oxide layer provides superior attachment of the semiconductor die to the die pad and prevents delamination of the semiconductor die from the die pad.

## Description

### Background of the Invention

The present invention relates in general to semiconductor packaging and, more particularly, to attaching a semiconductor die to a die pad.

Recent improvements in design and manufacture of semiconductor devices involve using transistors with extremely small geometries to achieve very high density circuit designs, sometimes called Ultra Large Scale Integration (ULSI). The previous generation of semiconductor circuits is known as Very Large Scale Integration (VLSI). ULSI circuits are commonly used in computers and communication equipment and may have a much greater number of input/output pins and superior electrical performance than VSLI circuits.

In order to assemble the semiconductor circuits for use in the computer or communications device, the semiconductor dies are attached to an integrated circuit (IC) package, and the IC packages are mounted on a printed circuit board. The process of mounting of the semiconductor die to a package must fulfill several requirements including good electrical conduction between the die leads and package leads, good heat conduction to dissipate the heat generated by the semiconductor die, and good attachment of the IC die to the die pad of the package.

Plastic ball grid array packages, also known as over-molded pad array carrier (OMPAC) are a low cost, high density packaging solution for advanced ULSI circuits. Building the OMPAC package typically involves attaching a semiconductor die using organic die attach material to a die pad made of gold-plated copper patterned on the printed circuit board. After attaching the semiconductor die to the gold-plated die pad, the package is wire bonded and over-molded with an epoxy based encapsulation. Gold plating works well for wire bond pads because it is a good electrical and heat conductor for metal-to-metal unions. The back side of the OMPAC package is attached with solder balls for signal transmission and heat dissipation. The OMPAC package is in turn attached to the printed circuit board, commonly known as the mother board, at the end user site using a reflow solder process such as IR, vapor phase or wave solder at temperatures typically between 215°C-260°C.

Unfortunately, the gold-plated copper has poor adhesive properties to most organic materials, including die attach material and encapsulants. The OMPAC packages comprise many organic materials. For example, the printed circuit board in the OMPAC package may be made of a bismaleimide triazine-epoxy composite commonly termed BT. Other organic materials include an organic die attach and the epoxy based encapsulant. These materials absorb moisture during shipping and storage at the end user site. The moisture combines with heat during reflow soldering generating tremendous internal steam stress which usually delaminate the weakest interface in the package.

With the conventional plastic ball grid array package, the weakest interface is very often between the die attach and die pad. The delaminated interface relieves the moisture vapor pressure but causes a high peeling stress at the adjoining encapsulant/die pad interface causing it to delaminate and eventually fracture the OMPAC package. The crack normally propagates to the outside surface of the package along the resin-fiber interface thereby compromising the integrity and reliability of the package.

One solution is to ship the OMPAC packages with a dessicant to prevent moisture absorption. The end user should mount the packages to the mother board typically within 96 hours after opening the dessicant bags to prevent delamination. This option is undesirable because of the high expense and the fact that customers lose the flexibility of their manufacturing process.

Hence, a need exists for a die pad surface which adheres better to liquid polymers including the mold compound and die attach adhesive.

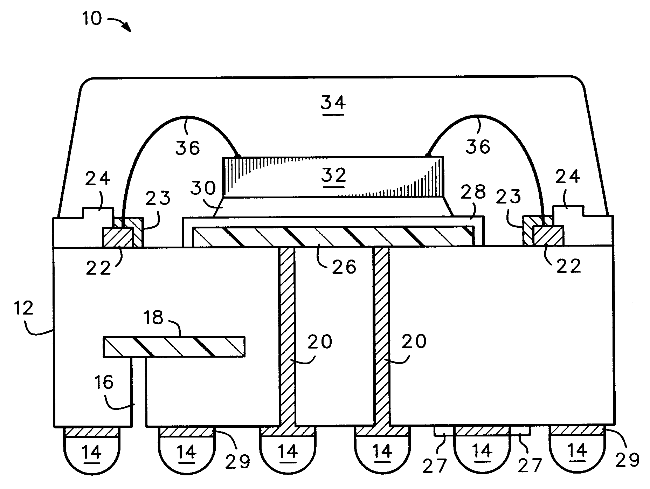

### Brief Description of the Drawing

The sole figure illustrates a semiconductor die attached to a die pad in a plastic ball grid array package.

### Detailed Description of the Preferred Embodiment

The preferred embodiment of the present invention includes chemically growing brown oxide (predominantly cuprous oxide) or black oxide (predominantly cupric oxide) on the surface of a die pad. The oxide layer provides excellent adhesion to bond a semiconductor die to the die pad.

Chemical oxides of copper can be formed with a variety of compositions and morphologies. Black oxide is commonly used because of its uniform black appearance, a structure comprised mostly of cupric oxide with acircular or needle-like morphology. Less common are brown, bronze and red oxides, defined by the appearance of the color interpreted by the observer. These oxides are mainly cuprous oxide, having a rough surface texture and a tangled network of interattached blocks. The adhesion of the cuprous brown oxide structures is considerably enhanced over the cupric black oxide and is preferred for situations where superior adhesion to liquid polymers is required. Therefore, cuprous oxide structures are preferred for depositing on the die pad to improve polymer adhesion, although cupric oxide and mixtures of cuprous and cupric oxides will also work

The sole figure illustrates a cross-sectional view of plastic ball grid array package 10. Substrate 12 in package 10 may be part of a single-layer or multi-layer printed circuit board processed by conventional methods. The common organic resin material used to manufacture the printed circuit board is a bismaleimide triazine-epoxy composite (BT). BT is a material with desirable properties at the higher temperatures required by users of semiconductor devices, as well as exhibiting reasonable cost and relatively good dimensional and moisture properties. A wire bond pad 22 is patterned into copper and laminated on the top BT layer of substrate 12 to create a conductive medium to carry electrical signals to and from integrated circuit semiconductor die 32. Die pad 26 is etched on the upper surface of the circuit package. A bonding pad 29 is also laminated with copper on the bottom of substrate 12 to attach solder balls 14. The copper is patterned using conventional photoimaging methods. Vias 16 and 20 and internal power and/or ground planes 18 may be present in the interior of the multi-layer printed circuit board structure. Vias 16 and 20 provide electrical and thermal conduction.

On the top surface of the printed circuit board, solder mask 24 covers a portion of the patterned copper up to wire bond pads 22. Exposed areas of wire bonding pads 22 are covered with gold-plating 23 for metal-to-metal union to bonding wires 36. No wire bonding occurs to solder mask 24. The exposed gold-plated wire bond pads 22 have either gold or aluminum wires 36 bonded first to the surface bond pad on semiconductor die 32 and then to wire bond pad 22 on the printed circuit board substrate.

As a key feature of the present invention, cuprous oxide layer 28 is chemically grown and disposed on the surface of die pad 26. A die attach adhesive resin 30, normally electrically or thermally conductive, is deposited on oxide layer 26 to bond semiconductor die 32 to die pad 26. Die attach adhesive 30 is normally epoxy or polyimide based resins, although other materials such as silicone are also possible. Semiconductor die 32 is thus bonded to die pad 26 through oxide layer 26 and die attach adhesive 30.

Following die bonding and wire bonding, substrate 12 is over-molded with a conventional epoxy based molding compound 34, to fully protect the delicate integrated circuit device both during handling and from environmental stresses. Molding compound 34 is disposed over the upper surface of semiconductor die 32 and makes contact with die pad 26. Oxide layer 26 also improves bonding between molding compound 34 and die pad 26.

Solder balls 14 about 25 mils in diameter of approximately eutectic composition of tin and lead are attached to gold-plated solder pads 29 on the back side of the printed circuit board. Each solder pad is surrounded by solder mask 27 to contain the solder flow. Solder pads 29 are generally first fluxed. A solder ball like 14 is attached to the liquid flux, and then reflowed in a furnace above the eutectic temperature of the solder. The solder balls collapse somewhat and after cooling, are firmly attached to the printed circuit board substrate remaining rugged during subsequent handling processes.

There are several alternatives for depositing copper oxide layer 28 selectively on die pad 26 on the printed circuit board's front side. In one process, oxide layer 28 is deposited after patterning the copper and either before or after depositing solder mask 24. The process further involves depositing a photoresist over the entire substrate 12, creating an opening in the photoresist only over die pad 26, exposing the entire substrate 12 to the chemical oxidation process which creates the structure only on the die pad surface, and removing the photoresist from the entire structure. The photoresist must be able to withstand the chemicals used to create the oxide structure and would have to selected carefully.

Because the adhesion of epoxy based polymers has been demonstrated to be very good to chemically grown oxide surfaces, and especially to cuprous oxide structures, other advantages can be gained related to the size and design of die pad 26 relative to the size and shape of the integrated circuit device. Die pad 26 contributes little or no moisture to the aforementioned steam stress during reflow soldering, due to it's very low solubility and diffusivity for water between 25°C-250°C. The BT-epoxy resin in the printed circuit board can contribute considerable moisture to the steam stress in die attach resin 30 if the printed circuit board resin comes into direct contact with die attach resin 30. A preferred design therefore is to have die pad 26 overhang the edge of semiconductor die 32 sufficiently that the excessive flow of die attach resin 30 does not reach the edge of die pad 26, leaving a region around the entire periphery of die pad 26 that makes intimate contact with mold compound 34. This ensures a seal between the printed circuit board resin and die attach 30 prohibiting moisture from the printed circuit board resin from reaching die attach resin 30 during reflow soldering.

The advantages of oxide treatment apply equally well to chip-on-board applications where semiconductor devices are bonded to the surface of a patterned printed circuit board, with copper as the conducting layer.

While specific embodiments of the present invention have been shown and described, further modifications and improvements will occur to those skilled in the art. It is understood that the invention is not limited to the particular forms shown and it is intended for the appended claims to cover all modifications which do not depart from the spirit and scope of this invention.

## Claims

1. A circuit package, comprising:
a die pad (26) etched on a surface of the circuit package (12);
an oxide layer (28) disposed on a surface of said die pad;
a die attach adhesive (30) disposed on top of said oxide layer; and
a semiconductor die (32) bonded to said die pad through said die attach adhesive and said oxide layer.

2. The circuit package of claim 1 wherein said oxide layer includes cuprous oxide.

3. The circuit package of claim 2 wherein said oxide layer includes cupric oxide.

4. A method of bonding a semiconductor die to a die pad, comprising the steps of:
etching a die pad (26) from a surface of a substrate (12);
depositing an oxide layer (28) on top of the die pad;
depositing a die attach adhesive (30) on top of said oxide layer; and
bonding the semiconductor die to the die pad through said die attach adhesive and said oxide layer.

5. The method of claim 4 further including the steps of:
depositing a photoresist over said substrate;
creating an opening in said photoresist over the die pad;
exposing said substrate to a chemical oxidation process; and
removing said photoresist from said substrate.
